# EUROPÄISCHE PATENTSCHRIFT

(11) **EP 0 827 282 B1**
(45) Veröffentlichungstag und Bekanntmachung des Hinweises auf die Patenterteilung: **22.12.2004**
(21) Anmeldenummer: 96113797.3
(22) Anmeldetag: 29.08.1996
(51) Int. Cl.: H03K 19/003

(54) **Störstrahlreduzierende Anschlusskonfiguration für eine integrierte Schaltung**
Connection configuration for reducing noise radiation in an integrated circuit
Configuration de connexion réduisant les rayonnements pour un circuit intégré

(43) Veröffentlichungstag der Anmeldung: 04.03.1998
(73) Patentinhaber: Micronas GmbH, 79108 Freiburg (DE)
(72) Erfinder: Giebel, Burkhard, Dipl.-Ing., 79211 Denzlingen (DE); Theus, Ulrich, Dr. Ing., 79194 Gundelfingen (DE)

(56) Entgegenhaltungen:
- US-A- 4 710 771
- PATENT ABSTRACTS OF JAPAN vol. 013, no. 330 (E-793), 25.Juli 1989 & JP 01 094646 A (FUJITSU LTD), 13.April 1989,
- IBM TECHNICAL DISCLOSURE BULLETIN, Bd. 30, Nr. 3, August 1987, NEW YORK US, Seite 1280 XP002023092 "on-chip decoupling capacitor for logic vlsi chip"
- PATENT ABSTRACTS OF JAPAN vol. 013, no. 240 (E-767), 6.Juni 1989 & JP 01 042162 A (MITSUBISHI ELECTRIC CORP), 14.Februar 1989,

## Beschreibung

Die Erfindung betrifft eine störstrahlreduzierende Anschlußkonfiguration für eine integrierte Schaltung, insbesondere eine monolithisch integrierte Schaltung, die sich auch innerhalb eines Gehäuses oder einer Kunststoffumhüllung befinden kann.

Der Trend zur Integration einer immer größeren Anzahl von Funktionen in einer integrierten Schaltung führt zu immer kleineren Strukturabmessungen und zu immer höheren Verarbeitungsgeschwindigkeiten. Werden hierbei getaktete CMOS-Schaltungen verwendet, dann tritt der Strombedarf im hohen Maße taktsynchron und impulsförmig auf. Hybridschaltungen unterscheiden sich hierin nicht, wenn sie innerhalb eines Gehäuses neben analogen Schaltungen auch getaktete Schaltungen, insbesondere wieder CMOS-Schaltungen, mit steilen Stromimpulsflanken enthalten. Beispiele für getaktete Schaltungen mit hohem impulsförmigem Strombedarf sind Steuerwerke, Mikroprozessoren und digitale Signalprozessoren für die verschiedensten Anwendungsbereiche. Mit fortschreitender Miniaturisierung und der damit verbundenen Erhöhung der Schaltgeschwindigkeiten nimmt der Oberwellengehalt dieser impulsförmigen Versorgungs- und Lastströme ständig zu. Die Folge sind leitungsgeführte elektromagnetische Wellen, die die integrierte Schaltung auf den Versorgungs- und den I/O-Leitungen (I/O = Ein-/ Ausgang) verlassen. Dies kann bei zusammenwirkenden Schaltungsgruppen zu gegenseitigen Störungen oder über unzulässige elektromagnetische Abstrahlungen zu Störungen in anderen elektronischen Einrichtungen führen.

Ein kritischer Anwendungsfall für getaktete Schaltungen stellt der Kraftfahrzeugbereich dar, weil dort aus Kostengründen keine Abschirmmaßnahmen der gedruckten Leiterplatten (= Board) und der zugehörigen Anschlußleitungen möglich sind und sich die hochfrequenten Störungen über eine ungeschirmte Board-Anordnung leicht ausbreiten können. Die Störungen machen sich dann beispielsweise im Radio, Funkgerät, Autotelefon usw. bemerkbar. Insbesondere in diesem Anwendungsbereich hat die Diskussion über die EMV (= Elektromagnetische Verträglichkeit) in den letzten Jahren zur Definition von Abstrahlgrenzen geführt, denen neue Systeme genügen müssen.

Der Versuch, die Störungen durch eine Verdrosselung der Versorgungsleitungen am Verlassen der integrierten Schaltung zu hindern, führt leicht zu funktionsgefährdenden Fluktuationen in der Spannungsversorgung der integrierten Schaltung, wobei deren Mindestversorgungsspannung sogar kurzzeitig unterschritten werden kann. Die Verdrosselung der Versorgungsleitungen unterdrückt zudem die von den I/O-Leitungen geführten Störungen nicht. Ihre Beseitigung erfordert gesonderte Maßnahmen an jeder der vorhandenen I/O-Leitungen.

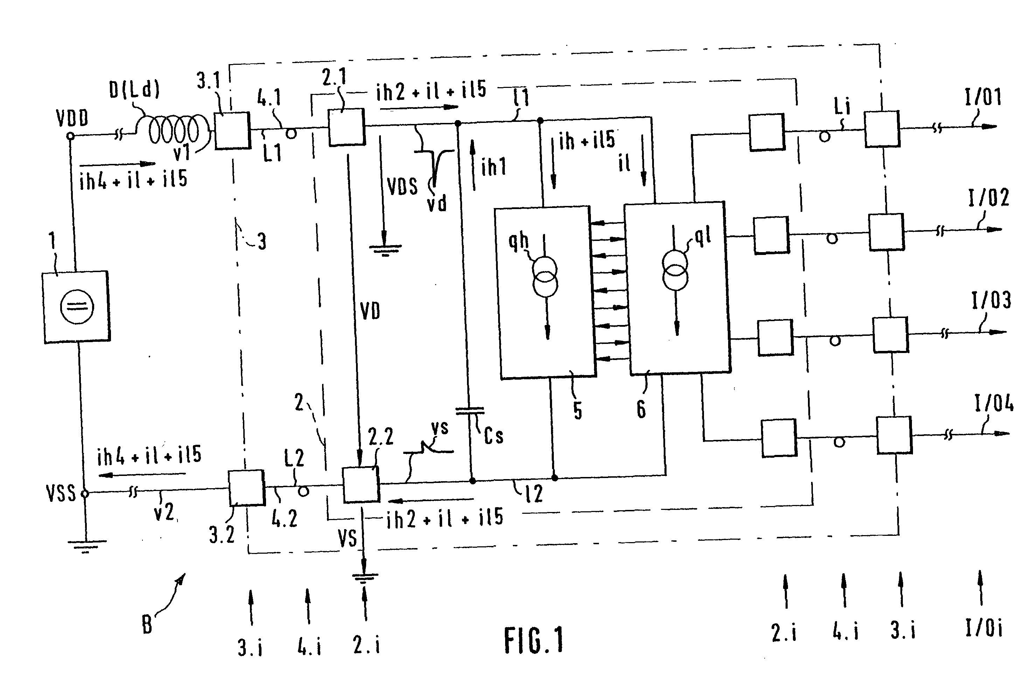

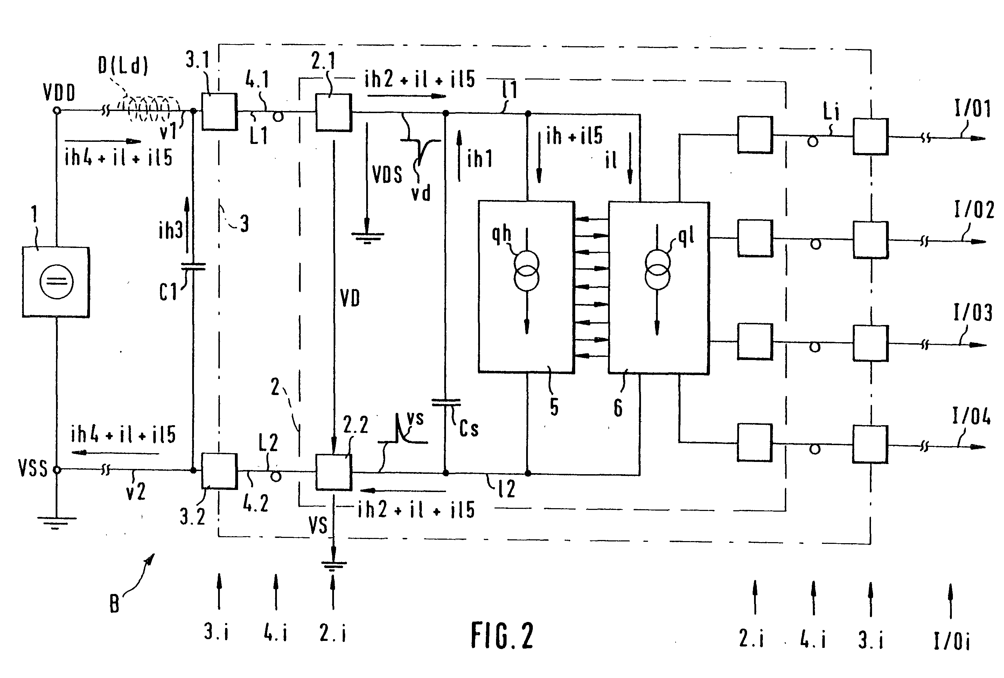

Wie sich die impulsförmigen Versorgungs- und Lastströme über die Versorgungs- und I/O-Leitungen eines ungeschirmten Board-Netz auswirken, wird anhand der zugehörigen hoch- und niederfrequenten Stromanteile schematisch in Fig. 1 und Fig. 2 dargestellt. Für die Betrachtung wird vereinfachend angenommen, daß die ohmschen Widerstände der dargestellte Netze klein gegenüber den wirksamen Blindwiderständen (= Reaktanzen) für die hochfrequenten Stromanteile sind.

Besonders unangenehm sind dabei Störungen, bei denen die hochfrequenten Stromkomponenten über relativ großflächige Stromschleifen geführt werden, denn die von den hochfrequenten Strömen umflossene Fläche definiert direkt die magnetisch abstrahlende Fläche und ist damit proportional zur abgestrahlten elektromagnetischen Energie. In erster Linie sind dabei die Versorgungsleitungen der getakteten Schaltstufen betroffen. Aber auch die Ausgangstreiber können über ihre I/O-Leitungen, deren verteilte Kapazitäten und die Eingangs-Kapazitäten der angeschlossenen Systeme, z.B. ein Anzeigedisplay, derartige Stromschleifen bilden, wobei die Stromrückführung über die Versorgungs- oder Masseverbindungsleitungen erfolgt. Bei I/O-Leitungen können sehr großflächige Stromschleifen auftreten, die dann in gleicher Weise als magnetisch abstrahlende Flächen wirksam werden. Aber auch ohne daß Ströme fließen, stören die I/O-Leitungen durch die kapazitive Abstrahlung der Schaltflanken und unerwünschter Pegelsprünge.

Neben einer geschickten I/O-Leitungs- und Masseführung lassen sich die Störungen durch die Schaltflanken auf den I/O-Leitungen dadurch reduzieren, daß die Schaltflanken verlangsamt werden oder das Schaltereignis nur sehr selten und unregelmäßig auftritt. Eine Verlangsamung der Schaltflanken der Ausgangstreiber ist jedoch nur zum Teil wirksam, wenn nach wie vor rasche Pegelschwankungen auf den I/O-Leitungen vorhanden sind. Die Ursache dieser unerwünschten Pegelschwankungen sind rasche Pegelschwankungen auf der Versorgungs- oder Massebezugsseite der jeweiligen I/O-Treiber. Eine wesentliche Rolle spielt hierbei, wie bereits erwähnt, die unzureichende Verdrosselung der Versorgungsleitungen. In jedem Fall wirken sich die Pegelschwankungen über die I/O-Leitungen als Störungen so aus, als wären I/O-Treiber mit steilen Schaltflanken vorhanden.

In JP 0 1 094 646 A (= Patent Abstracts of Japan, Vol 013, No. 330 (E-793), 25. Juli 1989) ist eine integrierte Schaltung beschrieben, die in einen analogen und digitalen Schaltungsblock aufgeteilt ist. Zur Vermeindung von Störsignaleinkopplungen aus dem digitalen Schaltungsblock in den analogen Schaltungsblock findet mindestens auf der Spannungseite oder Masseseite eine getrennte, Zuführung der Versorgungsspannung stalt, wobei die getrennten Versorgungsleitungen auch bezuglich ihrer nach außen führenden Bandkontakte getrennt sind. Die Abblockung der Störsignale erfolgt durch externe Abblockkondensatoren, die direckt mit den externen Gehäuseanschlüssen verbunden werden.

Es ist Aufgabe der Erfindung, mit kostengünstigen Mitteln das Abstrahlungsproblem auf den Versorgungs- und I/O-Leitungen eines ungeschirmen Board-Netzes zu lösen.

Die Lösung der Aufgabe erfolgt nach den Merkmalen des Anspruchs 1 Bei der Erfindung erfolgt die Zuführung dieser hoch- und niederfrequenten Stromkomponenten über getrennte Versorgungsstrompfade, die an externe Siebmittel angeschlossen sind und auf diese Weise eine geeignete Abblockung der hochfrequenten Stromkomponenten ermöglichen. Den gemeinsamen Massebezugspunkt bildet eine niederohmige und induktivitätsarme Verbindung auf der massebezogenen Seite der beiden Versorgungsstrompfade.

Durch die Trennung der Versorgungsstrompfade ist eine wirksame Abblockung der hochfrequenten Stromkomponenten im zugehörigen Versorgungsstrompfad möglich, ohne dabei die Zufuhr der Stromkomponenten im anderen Versorgungsstrompfad zu beeinflussen. Somit wird erreicht, daß die hochfrequenten Stromkomponenten, die

alleine die Störungen verursachen, von den externen Board-Leitungen isoliert werden, die mit der integrierten Schaltung als Versorgungs- oder I/O-Leitungen verbunden sind. Dadurch werden die kapazitiven und/oder elektromagnetischen Abstrahlungen über das ungeschirmte Board-Netz verhindert. Ferner wird für die niederfrequenten Schaltungsbereiche, insbesondere die I/O-Treiberschaltungen, ein ruhiges Versorgungs- und Massepotential zur Verfügung gestellt.

Die Erfindung betrifft ferner eine integrierte Schaltung, die als Chip-Version ohne Gehäuse oder als umhülltes Bauelement in einem derartigen ungeschirmten Board-Netz verwendet werden kann, wobei eine resultierende Störstrahlung ebenfalls nicht auftritt.

Die Erfindung und vorteilhafte Ausgestaltungen werden nun anhand der Figuren der Zeichnung näher erläutert:
Fig. 1 zeigt schematisch die Ersatzschaltung eines ungeschirmten Board-Netzes mit einer integrierten Schaltung, wobei die Versorgungsleitungen durch eine Drossel gegenüber den hochfrequenten Stromkomponenten abgeblockt sind,
Fig. 2 zeigt schematisch die Ersatzschaltung eines weiteren ungeschirmten Board-Netzes mit einer integrierten Schaltung, wobei die Versorgungsleitungen durch einen Abblockkondensator gegenüber den hochfrequenten Stromkomponenten abgeblockt sind und
Fig. 3 zeigt schematisch die Ersatzschaltung eines ungeschirmten Board-Netzes mit einer integrierten Schaltung, wobei aber die Anschlußkonfiguration nach der Erfindung eine wesentlich geringere Störstrahlwirkung zur Folge hat.

In Fig. 1 ist die Ersatzschaltung eines ungeschirmten Board-Netzes B dargestellt, bei dem die hochfrequenten Stromkomponenten ih der integrierten Schaltung 2 mittels einer Drossel D abgeblockt sind. Das Board-Netz B enthält als Funktions- und Schaltungseinheiten einen Spannungsregler 1 die integrierte Schaltung 2 in einem Gehäuse 3 oder einer Umhüllung, Versorgungsleitungen v1, v2, über die die integrierte Schaltung 2 an den Spannungsregler 1 angeschlossen ist, und schließlich einige mit der integrierten Schaltung 2 verbundene I/O-Leitungen I/O1 bis I/O4. Die räumliche Entfernung zwischen dem Spannungsregler 1 und der integrierten Schaltung 2 bzw. dem zugehörigen Gehäuse 3 wird durch die beiden Versorgungsleitungen v1, v2 überbrückt. Der Spannungsregler 1 liefert an seiner Ausgangsklemme das Versorgungspotential VDD. Seine andere Klemme VSS ist mit dem Massebezugspotential verbunden. Die Ausbildung der Massebezugsleitung v2 auf dem Board-Netz B sollte möglichst niederohmig und induktivitätsarm sein, damit für das gesamte Board möglichst ein ruhiges Bezugspotential zur Verfügung steht. Aus Kostengründen kann diese Forderung nur nährungsweise erreicht werden.

Die Quelle für die eigentlichen Störsignale liegt innerhalb der integrierten Schaltung 2 und wird durch die vielen taktgesteuerten Schaltstufen gebildet, über die im ungünstigsten Fall kurzzeitige Querströme fließen. Den Hauptstrombeitrag liefern jedoch eine Vielzahl von Gate-Kapazitäten, die taktsynchron auf- oder entladen werden. Die getakteten Stufen sind schematisch in einem Schaltungsblock 5 zusammengefaßt, der als Schaltungssymbol eine hochfrequente Stromquelle qh enthält. Ein zweiter Schaltungsblock 6 ist über eine Vielzahl von Signalleitungen mit dem Schaltungsblock 5 verbunden. Der zweite Schaltungsblock 6 enthält im wesentlichen solche Schaltungsteile, die keine hochfrequenten Ströme auf den Versorgungsleitungen erzeugen. Es handelt sich hierbei um analoge Schaltungen oder um Schaltungen, die an einen langsamen Verarbeitungstakt gekoppelt sind und damit nur langsame Schaltflanken erzeugen müssen. Hierzu zählen insbesondere die I/O-Schaltungen, die über I/O-Leitungen I/Oi Daten oder Signale austauschen. Im Schaltungsblock 6 werden die niederfrequenten Ströme il durch eine niederfrequente Stromquelle ql ersatzweise dargestellt.

Die integrierte Schaltung 2 weist an ihrer Peripherie Anschlußkontakte 2.i auf, die über Zwischenverbindungen 4.i mit entsprechenden Gehäuseanschlüssen 3.i verbunden sind. Die Gehäuseanschlüsse 3.i sind auf üblicher Weise mit den Leitungen des Board-Netzes B verbunden, beispielsweise durch eine Lötverbindung. Für die hochfrequenten Stromkomponenten ih sind die Leitungen 11, 12 bzw. v1, v2 auf der integrierten Schaltung 2 oder auf dem Board-Netz B nicht mehr ideal, sondern sie weisen neben ohmschen Widerständen auch leitungsbezogene Induktivitäten und entsprechende Streukapazitäten auf. Einen wesentlichen Beitrag zur Induktivität liefern die Zwischenverbindungen 4.i, die in der Regel als Bonddraht-Verbindungen ausgeführt sind. Die Induktivitäten L1, L2, Li weisen beispielsweise für einen Golddraht von 25 Mikrometer Durchmesser und 1,5 mm Länge einen Induktivitätswert von etwa 1, 5 nH auf.

Die integrierte Schaltung 2 enthält in der Regel einen internen Kondensator Cs, der einen Teil ih1 der hochfrequenten Ströme ih abblockt. Bei einer Hybridschaltung kann dieser Kondensator Cs ein zusätzliches Bauelement sein, das räumlich eng mit dem getakteten Schaltungsteil 5 verbunden ist, so daß die Wirksamkeit nicht durch induktivitätsbehaftete Zuleitungen behindert wird. Aber selbst bei einer monolithisch integrierten Schaltung kann ein interner Abblockkondensator Cs auf dem Chip, beispielsweise durch eine doppelte Verdrahtungsebene im Randbereich und auf Freiflächen, mitintegriert seien. Die Zuleitungsinduktivitäten sind dabei minimal. Leider ist die Größe der erreichbaren Kapazität aus Kosten und Flächengründen begrenzt.

Im Board-Ersatzschaltbild von Fig. 1 sind alle Funktionseinheiten, die für die hochfrequenten Stromkomponenten ih wichtig sind, angegeben. Von den Stromquellen qh, ql und den einzelnen Leitungswegen ausgehend sind die jeweiligen nieder- und hochfrequenten Stromkomponenten angegeben, die über die erste und zweite Versorgungsleitung v1, v2 letztendlich den Spannungsregler 1 erreichen. Der erste Schaltungsbereich 5 erzeugt die hochfrequente Stromkomponente ih und eine niederfrequente Stromkomponente il5, die auch einen Gleichstromanteil enthält. Der zweite Bereich 6 erzeugt die niederfrequente Stromkomponente il, die ebenfalls einen Gleichstromanteil als reinen Verbrauchsstrom enthält. Alle Stromkomponenten gelangen auf die erste bzw. Sammelschiene l1, l2, die mit dem ersten bzw. zweiten Anschlußkontakt 2.1, 2.2 der integrierten Schaltung 2 verbunden ist. Ein Teil ih1 der hochfrequenten Stromkomponente ih gelangt nicht auf die Anschlußkontakte 2.1, 2.2 sondern wird bereits durch den internen Kondensator Cs abgeblockt. Wie groß dieser Stromanteil ih1 im Vergleich zum verbleibenden hochfrequenten Stromanteil ih2 ist, hängt lediglich davon ab, wie groß die Admittanz des internen Kondensators Cs im Vergleich zur Admittanz des Versorgungspfades über den Spannungsreglers 1 ist. Diese wird in der Board-Anordnung B von Fig. 1 dadurch kleingehalten, daß in der ersten Versorgungsleitung v1 eine Drossel D mit der Induktivität Ld eingefügt ist, die zur Induktivität L1, L2 der beiden Zwischenverbindungen 4.1, 4.2 hinzukommt, wobei die Induktivität Ld der Drossel D um einige Größenordnungen höher ist als die Induktivität Li der Zwischenverbindungen 4.i.

Es ist auch möglich, daß der interne Kondensator Cs durch einen externen Kondensator ergänzt wird, der dann mit seinem einen Anschluß an der ersten Versorgungsleitung v1 zwischen der Drossel D und dem ersten Gehäuseanschluß 3.1 liegen müßte und mit seinem zweiten Anschluß mit der zweiten Versorgungsleitung v2 zu verbinden wäre, wobei die Anschlüsse möglichst dicht beim ersten und zweiten Gehäuseanschluß 3.1, 3.2 liegen sollten. In diesem Fall würde für einen Teil der hochfrequenten Stromkomponenten ih des ersten Bereiches 5 wieder ein Strompfad über die induktivitätsbehaftenden Zwischenverbindungen 4.1 bzw. 4.2 bereit stehen, der durch die Drossel D eigentlich verhindert werden sollte, vgl. hierzu den Kondensator C1 und die zugehörige hochfrequente Stromkomponente ih3 in Fig. 2. Die von der Drossel D noch durchgelassene hochfrequente Stromkomponente ih4 ist in Fig. 1 (also ohne den externen Kondensator C1) identisch mit der Stromkomponente ih2, die über die Zwischenverbindungen 4.1, 4.2 geführt ist.

Aus dem Ersatzschaltbild von Fig. 1 ist erkennbar, daß die hochfrequenten Stromkomponenten ih2 bzw. ih4 einen taktbezogenen Spannungsabfall an der Drossel D und den Induktivitäten L1, L2 bewirken, so daß an den Anschlußkontakten 2.1, 2.2 nur noch eine reduzierte Versorgungsspannung VD zur Verfügung steht. Die Spannung VD unterliegt zeitlichen Fluktuationen, die insbesondere mit dem Takt synchronisiert sind und nadelförmige Spannungseinbrüche aufweisen. Dabei schwankt sowohl das interne Versorgungspotential VDS als auch das interne Massebezugspotential VS. In Fig. 1 ist dies durch nadelförmige Spannungsverläufe vd, vs schematisch dargestellt. Je nach der Größe der Induktivität Ld der Drossel D im Vergleich zu den Induktivitäten L1, L2 der beiden Zwischenverbindungen 4.1, 4.2 und der beiden Versorgungsleitungen v1, v2 verschieben sich die nadelförmigen Spannungseinbrüche vd, vs mehr oder weniger vollständig auf die Versorgungsspannungsseite. Bei der relativ großen Induktivität Ld der Drossel D ist der nadelförmige Spannungseinbruch vs auf der Masseseite gegenüber dem Spannungseinbruch vd auf der Versorgungsseite vernachlässigbar. Dies wirkt sich entsprechend auf die Ausgangssignale der Treiberstufen im zweiten Schaltungsbereich 6 aus. Je nach dem Logikzustand schalten die Treiberstufen die externen I/O-Leitungen auf das interne Versorgungspotential VDS oder das interne Massebezugspotential VS durch. Die nadelförmigen Spannungseinbrüche vd, vs dieser Potentiale übertragen sich damit niederohmig auf die I/O-Leitungen. Die nadelförmigen Pegelschwankungen führen somit zu steilen Spannungsspitzen und/oder Ausgleichsströmen. Damit entstehen kapazitive oder induktive Störquellen.

Bei der angesprochenen Ergänzung der Drossel D durch einen externen Kondensator C1 nähern sich die nadelförmigen Spannungseinbrüche vd, vs in ihrer Größe einander an, wobei die gegensinnige Polarität erhalten bleibt. Dies hat die Ursache in dem relativ induktivitätsarmen Strompfad über den Kondensator C1, über den die hochfrequente Stromkomponente ih3 fließen kann (vgl. Fig. 2). Im Vergleich zum induktivitätsbehaftenden Strompfad über die Drossel D ist die Stromkomponente ih3 wesentlich (das kann z.B. Größenordnungen ausmachen) größer als die Stromkomponente ih4. Beide Stromkomponenten ih3, ih4 fließen gemeinsam über die Zwischenverbindungen 4.1, 4.2 und verursachen über deren Induktivitäten L1, L2 die nadelförmigen Spannungseinbrüche vd, vs, die bei gleichen Induktivitäten L1, L2 auch gleich groß ausfallen. Die Reduktion der Spannungseinbrüche vd auf der internen Versorgungsseite VDS wird durch eine Verschlechterung des internen Massepotentials Vs erkauft. Durch den externen Kondensator C1 wird also die Funktion der Entstörmaßnahmen wesentlich geändert - im Grunde genommen handelt es sich dabei um eine andere Entstörmaßnahme, die eher der Entstörung von Fig. 2 entspricht.

In dem Board-Ersatzschaltbild von Fig. 2 sind im wesentlichen die gleichen Schaltungs- und Funktionseinheiten enthalten wie in dem Ersatzschaltbild von Fig. 1. Gleiche Teile sind dabei mit gleichen Bezugszeichen versehen, so daß sich eine nochmalige Erörterung erübrigt. Der wesentliche Unterschied von Fig. 2 zu Fig. 1 liegt in der Ausbildung der äußeren Siebmittel, mit denen die hochfrequenten Stromkomponenten ih von der ersten und zweiten Versorgungsleitung v1, v2 abgehalten werden sollen. In Fig. 1 erfolgt dies mittels der Drossel D in der ersten Versorgungsleitung v1. In Fig. 2 besteht das wesentliche Siebmittel in dem externen Kondensator C1. Die Anordnung nach Fig. 2 hat gegenüber Fig. 1 den Vorteil, daß der möglichst nahe beim Gehäuse 3 liegende Kondensator C1 die hochfrequenten Stromkomponenten ih3 für die integrierte Schaltung 2 bereitstellt, für die der Spannungsregler 1 zu langsam ist. Zusätzlich kann in der ersten Versorgungsleitung v1 eine Drossel D eingefügt werden, vgl. die ergänzenden Ausführungen zu Fig. 1. Die Kombination von Drossel D und Kondensator C1 in den externen Versorgungsleitungen v1, v2 kann in Fig. 1 und Fig. 2 jedoch auch problematisch sein, weil dadurch ein Schwingkreis gebildet wird, der zu Eigenschwingungen angeregt werden kann.

Die Wirkung der Entstörschaltung nach Fig. 2 im Vergleich zu Fig. 1 besteht innerhalb der Board-Anordnung B darin, daß in Fig. 2 die gegensinnigen Spannungseinbrüche vd, vs an den internen Versorgungsanschlüssen 2.1, 2.2 zueinander etwa gleich groß sind, wohingegen die Größe des Spannungseinbruches vd für sich genommen deutlich kleiner, z.B. nur halb so groß, wie in Fig. 1 ist. Dies wird dadurch erkauft, daß die nadelförmige Spannungsspitze vs auf dem internen Massepotential VS nicht mehr vernachlässigbar wie in Fig. 1 ist. Die Unterschiede der Entstörschaltungen nach Fig. 1 und Fig. 2 machen sich über die jeweiligen Treiber in den I/O-Leitungen bemerkbar, die auch ohne Änderung des jeweiligen Schaltzustandes die Spannungsspitzen vd, vs niederohmig als Störsignale auf die I/O-Leitungen übertragen.

In der Board-Anordnung B von Fig. 2 wird die hochfrequente Stromkomponente ih des ersten Bereiches 5 durch den internen Kondensator Cs in die Komponenten ih1, ih2 aufgeteilt, wobei die Komponente ih2 über die Zwischenverbindungen 4.1, 4.2 an die Gehäuseanschlüsse 3.1, 3.2 geführt wird. Dort teilt sich die Komponente ih2 in die hochfrequenten Stromkomponenten ih3, ih4 auf. Die Komponente ih3 fließt über den externen Kondensator C1 und die Komponente ih4 letztendlich über den Spannungsregler 1. Für die nadelförmigen Spannungseinbrüche vd, vs an den internen Versorgungsanschlüssen 2.1, 2.2 sind wie in Fig. 1 die einzelnen hochfrequenten Stromkomponenten ih4 bzw. ih2 und die Induktivitäten Ld, bzw. L1, L2 des Versorgungsstrompfades verantwortlich.

Aus den beiden Ersatzschaltbildern von Fig. 1 und Fig. 2 ist ersichtlich, daß mit externen Siebmitteln D, C1 nur eine begrenzte Entstörung möglich ist, indem die nadelförmigen Impulse vd, vs entweder mehr auf die Versorgungsspannungsseite oder mehr auf die Massebezugsseite verlagert werden. Die angeführten Siebmittel D, C1 sind zudem nicht selektiv genug, so daß auch stets die jeweils andere Stromkomponente nachteilig beeinflußt wird.

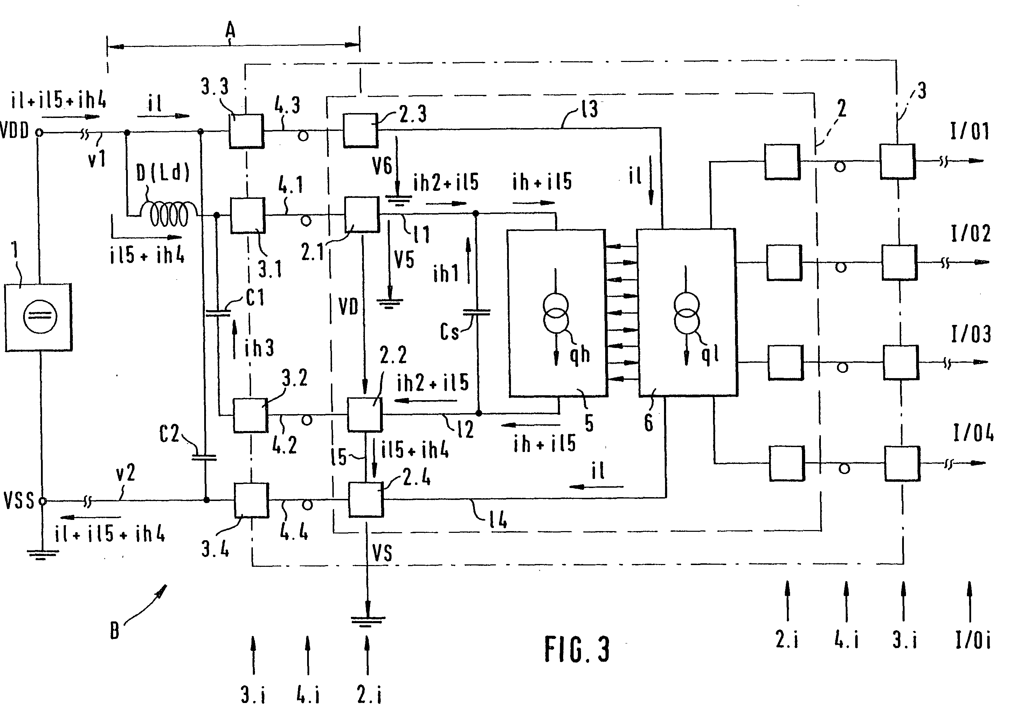

Das in Fig. 3 schematisch dargestellte Board-Netz B, das die integrierte Schaltung 2 mit der Anschlußkonfiguration nach der Erfindung zeigt, enthält im wesentlichen die gleichen Funktionseinheiten wie in den Board-Netzen B von Fig. 1 und Fig. 2. Da in allen drei Figuren gleiche Schaltungs- oder Funktionseinheiten mit gleichen Bezugszeichen versehen sind, erübrigt sich eine Wiederholung der zugehörigen Beschreibung. Im Gegensatz zur Anschlußkonfiguration von Fig. 1 und Fig. 2, bei der die ersten und zweiten Schaltungsbereiche 5 bzw. 6 bezüglich ihrer jeweiligen Versorgungsströme ih + il5 bzw. il an gemeinsame interne Versorgungsleitungen I1, I2 angeschlossen sind, sind in der Anschlußkonfiguration von Fig. 3 auch die internen Versorgungsleitungen für die ersten und zweiten Bereiche 5, 6 vollständig voneinander getrennt. Die ersten Bereiche sind über die erste Leitung 11 mit dem ersten Anschlußkontakt 2.1 und über die zweite Leitung 12 mit dem zweiten Anschlußkontakt 2.2 verbunden. Der interne Kondensator Cs, der zwischen der ersten und zweiten Leitung I1, I2 liegt, blockt wie in Fig. 1 oder Fig. 2 einen Teil ih1 der hochfrequenten Stromkomponente ih der ersten Bereiche 5 ab.

Für die zweiten Bereiche 6 erfolgt die separate Zufuhr der Versorgungsspannung bzw. des Massepotentials über eine dritte bzw. vierte Leitung 13 bzw. l4, die mit einem dritten bzw. vierten Anschlußkontakt 2.3 bzw. 2.4 verbunden ist. Die getrennte Zufuhr der Versorgungsströme setzt sich auch im Bereich der Zwischenverbindungen 4.i und der Gehäuseanschlüsse 3.i fort. So ist eine dritte und vierte Zwischenverbindung 4.3, 4.4 und ein dritter und vierter Gehäuseanschluß 3.3, 3.4 vorhanden. Wie in Fig. 2 ist der externe Abblockkondensator C1 für die hochfrequenten Stromkomponenten mit dem ersten und zweiten Gehäuseanschluß 3.1, 3.2 verbunden.

Über den externen Abblockkondensator C1 fließt die hochfrequente Stromkomponente ih3, die entsprechend der Erfindung möglichst identisch mit der hochfrequenten Stromkomponente ih2 an den Anschlußkontakten 2.1 und 2.2 sein soll. Das ist nur möglich, wenn die verbleibende Stromkomponente ih4, die über den Spannungsregler 1 fließen müßte, vernachlässigbar wird, also zu Null geht. Dies wird durch eine Drossel D erreicht, die zwischen dem ersten Gehäuseanschluß 3.1 mit dem angeschlossenen Kondensator C1 und der ersten Versorgungsleitung v1 eingefügt ist und deren Reaktanz unabhängig von den niederfrequenten Stromkomponenten il der zweiten Bereiche 6 hoch genug vorgegeben werden kann.

Der dritte und vierte Gehäuseanschluß 3.3, 3.4 wird zweckmäßigerweise durch einen weiteren externen Kondensator C2 überbrückt, der jedoch bezüglich der hochfrequenten Stromkomponenten des ersten Bereiches 5 keine Funktion hat, sondern lediglich dem Strombedarf il des zweiten Bereichs 6 dient. Hochfrequente Stromkomponenten, die gegebenenfalls auch im zweiten Bereich 6 auftreten, finden über den Kondensator C2 einen induktivitätsarmen Abblockstrompfad wie in Fig. 2 und gelangen somit allenfalls reduziert auf die Versorgungsleitungen v1, v2. Die Stromaufnahme il der I/O-Treiber ist zudem im Schaltvorgang größer als die Stromergiebigkeit des Reglers 1, dessen Grenzfrequenz beispielsweise bei 1 Megahertz liegt. Der Kondensator C2 hat somit auch eine Pufferfunktion.

Die Aufspaltung der ersten und zweiten Versorgungsleitung v1, v2 auf die getrennten Versorgungsstrompfade im Gehäuse 3 und in der integrierten Schaltung 2 erfolgt in der Art einer Stromweiche durch die externen Siebmittel D, C1, C2 auf der Board-Anordnung B. Vergleiche hierzu in Fig. 3 den Anschlußbereich A, der die getrennten Versorgungsstrompfade auf dem Board B räumlich eingrenzt. Der niederfrequente (= il5) und der restliche, gegen Null gehende hochfrequente Stromanteil ih4 für die ersten Bereiche 5 fließt über die Drossel D, die auf der einen Seite mit der ersten Versorgungsleitung v1 und auf der anderen Seite mit dem ersten Gehäuseanschluß 3.1 verbunden ist. Die Ausführung der Drossel D ist beliebig, in der Regel wird hierzu aus Kostengründen und der kompakten Bauform wegen Ferritmaterial verwendet.

Die Rückführung der niederfrequenten Stromanteile il5 zum Spannungsregler 1 erfolgt über eine niederohmige und induktivitätsarme Verbindung 15 zwischen dem zweiten und vierten Anschlußkontakt 2.2, 2.4. Nach dem vierten Anschlußkontakt 2.4 werden die beiden Stromkomponenten il, il5 gemeinsam über die vierte Zwischenverbindung 4.4, den vierten Gehäuseanschluß 3.4 und schließlich die zweite Versorgungsleitung v2 geführt. Die niederohmige und induktivitätsarme Verbindung 15 sollte nicht als Bondverbindung ausgebildet sein, damit die verbleibende hochfrequente Stromkomponente ih4, die der Stromkomponente il5 überlagert ist, über die Bonddrahtinduktivität das interne Massepotential VS nicht beeinflussen kann.

Aus dem Schaltungsschema von Fig. 3 mit den eingezeichneten Stromkomponenten ist ersichtlich, daß die hochfrequenten Stromkomponenten ih, ih2, ih3 des ersten Bereiches - außer der gegen Null gehende Stromkomponente ih4 - völlig von den niederfrequenten Stromkomponenten il des zweiten Schaltungsbereiches 6 innerhalb des gesamten Board-Netzes B getrennt sind. Damit bleibt das interne Bezugspotential VS ungestört und weist einen ruhigen Pegel auf, der im wesentlichen identisch mit dem Bezugspegel VSS des Spannungsreglers 1 ist.

Die getrennten Strompfade für die beiden Schaltungsbereiche 5, 6 haben weiter den Vorteil, daß die Drossel D nicht mehr in der Größe beschränkt ist, weil über sie nur noch die niederfrequenten Stromkomponenten il5 der ersten Bereiche 5 und bis auf den gegen Null gehenden Reststrom ih4 keinerlei hochfrequente Stromkomponenten geführt werden müssen. Die Selektivität der Drossel D ist daher nur insofern von Interesse, daß sie ausreicht, die hochfrequenten Stromkomponenten ih, ih2, ih3 von den Versorgungsleitungen v1, v2 zurückzuhalten. Die resultierende Resonanzfrequenz, die durch die Drossel D und den Kondensator C1 gebildet wird, liegt dabei so tief, daß eine Abstrahlung elektromagnetischer Wellen als Störstrahlung nicht auftritt. Durch eine geeignete Wahl der inneren Dämpfung des Schwingkreises wird das Schwingen in jedem Fall unterbunden. Weil durch diese Anschlußkonfiguration sichergestellt wird, daß die zweiten Schaltungsbereiche 6 mit den Treiberstufen an einer ruhigen internen Versorgungsspannung V6 bzw. an einem ruhigen internen Masse-Bezugspotential Vs liegen, wird erreicht, daß auf den I/O-Leitungen keine raschen Pegelsprünge auftreten. Dies ist ein wesentlicher Grund für die störstrahlreduzierende Wirkung der beschriebenen Anschlußkonfiguration. Es ist dabei selbstverständlich, daß die abstrahlenden Flächen, die durch Stromschleifen im Bereich der Versorgungsleitungen v1, v2 und im Bereich der I/O-Leitungen gebildet werden, so klein wie möglich zu halten sind.

## Patentansprüche

1. Integrierte Schaltung (2) mit einer störstrahlreduzierenden Spannungsversorgung, die innerhalb einer ungeschirmten Board-Anordnung (B) betreibbar ist, wobei
- die integrierte Schaltung (2) in erste Bereiche (5), die im wesentlichen hochfrequente Stromkomponenten (ih) aufweisen, und in zweite Bereiche (6), die im wesentlichen niederfrequente Stromkomponenten (il) aufweisen, getrennt ist, dabei bezieht sich die Trennung Spannungsseitig und masseseitig auch auf interne Versorgungsleitungen (I1,I2, I3,I4) und Versorgungs-Anschlußkontakte (2.1, 2.2, 2.3, 2.4),
- die zweiten Bereiche (6) Treiberschaltungen enthalten, die mit I/O-Leitungen (I/Oi, I/O1 bis I/O4) auf der Board-Anordnung (B) verbunden sind,
- die getrennte Zufuhr von Versorgungsströmen (ih, il5 bzw. il) für die ersten und zweiten Bereiche (5,6) sowohl spannungsseitig als auch masseseitig mindestens innerhalb eines durch externe, eine Drossel (D) enthaltende, Siebmittel (C1, C2, D) und die Versorgungs-Anschlußkontakte (2.1, 2.2, 2.3, 2.4) räumlich definierten Anschlußbereiches (A) hochfrequenzmäßig getrennt erfolgt, und zwar über einen ersten und einen davon sowohl Spannungsseitig als auch masseseitig getrennten zweiten Versorgungsstrompfad (3.1, 4.1, 2.1, I1, I2, 2.2, 4.2, 3.2 bzw. 3.3, 4.3, 2.3, l3, l4, 2.4, 4.4, 3.4), und
- auf der Massebezugsseite der erste und zweite Versorgungsstrompfad zur Bildung eines Massebezugspunktes (VS, 2.4) für die integrierte Schaltung (2) niederohmig und induktivitätsarm innerhalb der integrierten Schaltung (2) miteinander verbunden (I5) sind.

2. Integrierte Schaltung nach Anspruch 1, **dadurch gekennzeichnet, daß** die externen Siebmittel (C1, C2, D) einen ersten Abblockkondensator (C1) und die Drossel (D) enthalten, wobei
- der erste Abblockkondensator (C1) den ersten Versorgungsstrompfad (3.1, 4.1, 2.1, l1, l2, 2.2, 4.2, 3.2) für diejenigen hochfrequenten Stromkomponenten (ih3) extern schließt, die nicht mittels eines internen Abblockkondensators (Cs) abgeblockt sind, und
- die Drossel (D) den ersten Versorgungsstrompfad (3.1, 4.1, 2.1, l1, l2, 2.2, 4.2, 3.2) mit dem zweiten Versorgungsstrompfad (3.3, 4.3, 2.3, l3, l4, 2.4, 4.4, 3.4) jeweils auf der masseabgewandten Versorgungsspannungsseite verbindet.

3. Integrierte Schaltung (2) nach Anspruch 1 oder 2, **dadurch gekennzeichnet, daß** die Siebmittel (C1, C2, D) einen zweiten Abblockkondensator (C2) enthalten, der den zweiten Versorgungsstrompfad (3.3,4.3,2.3,I3,I4,2.4,4.4,3.4) für hochfrequente Stromkomponenten des zweiten Bereichs (6) kurzschließt.

## Claims

1. An integrated circuit (2) with a spurious-emission-reducing voltage supply which is operable within an unshielded board network (B),
- the integrated circuit (2) being separated into first subcircuits (5), which have essentially radio-frequency current components (ih), and second subcircuits (6), which have essentially low-frequency current components (il), the separation also extending, on a voltage side and a grounded side, to internal supply lines (I1, I2, I3, I4) and supply contact pads (2.1, 2.2, 2.3, 2.4),
- wherein the second subcircuits (6) include driver circuits which are connected to I/O lines (IOi, I/O1 to I/O4) on the board network (B),
- wherein both on the voltage side and on the grounded side, the separate supply of supply currents (ih, i15 and il) for the first and second subcircuits (5 and 6) takes place separately with respect to radio frequencies at least within a connection section (A) spatially defined by external filter means (C1, C2, D) comprising a choke (D) and by the supply contact pads (2.1, 2.2, 2.3, 2.4), namely over a first supply current path (3.1, 4.1, 2.1, I1, I2, 2.2, 4.2, 3.2) and a second supply current path (3.3, 4.3, 2.3, 13, 14, 2.4, 4.4, 3.4), which is separated from the first supply current path both on the voltage side and on the grounded side, and
- wherein on the grounded side, the first and second supply current paths are interconnected (I5) through a low resistance and a low inductance to establish a ground point (VS, 2.4) for the integrated circuit (2).

2. An integrated circuit (2) as claimed in claim 1, **characterized in that** the external filter means (C1, C2, D) comprise a first blocking capacitor (C1) and the choke (D),
- the first blocking capacitor (C1) closing the first supply current path (3.1, 4.1, 2.1, I1, I2, 2.2, 4.2, 3.2) externally for those radio-frequency current components (ih3) which are not blocked by an internal blocking capacitor (Cs), and
- the choke (D) connecting the first supply current path (3.1, 4.1, 2.1, I1, I2, 2.2, 4.2, 3.2) to the second supply current path (3.3, 4.3, 2.3, I3, I4, 2.4, 4.4, 3.4) on an ungrounded supply voltage side.

3. An integrated circuit (2) as claimed in claim 1 or 2, **characterized in that** the filter means (C1, C2, D) comprise a second blocking capacitor (C2), which short-circuits the second supply current path (3.3, 4.3, 2.3, I3, I4, 2.4, 4.4, 3.4) for radio-frequency current components of the second subcircuit (6).

## Revendications

1. Circuit intégré (2) comportant une alimentation en tension qui réduit les rayonnements parasites et qui peut fonctionner à l'intérieur d'un dispositif à plaque de circuit imprimé non blindé (B), dans lequel :
- le circuit intégré (2) est séparé en des premières zones (5), qui comportent essentiellement des composantes de courant à haute fréquence (ih), et en des deuxièmes zones (6), qui comportent essentiellement des composantes de courant à basse fréquence (il), la séparation concernant aussi, du côté de la tension et du côté de la masse, des lignes d'alimentation (I1, I2, I3, I4) et des contacts de connexion d'alimentation (2.1, 2.2, 2.3, 2.4),
- les deuxièmes zones (6) contiennent des circuits d'attaque qui sont reliés à des lignes d'entrée/sortie (I/Oi, IO/1 à I/O4) qui se trouvent sur le dispositif à plaque de circuit imprimé B,
- on réalise de manière séparée, en ce qui concerne les hautes fréquences, le transfert de courants d'alimentation (ih4, il5 ou il) pour les premières et deuxièmes zones (5,6), aussi bien du côté de la tension que du côté de la masse, au moins à l'intérieur d'une zone de connexions (A) qui est définie dans l'espace par des moyens de filtrage (C1, C2, D) externes qui comprennent une bobine (D) et par les contacts de connexion d'alimentation (2.1, 2.2, 2.3, 2.4), et cela par l'intermédiaire d'un premier et d'un deuxième trajets de courant d'alimentation (3.1, 4.1, 2.1, I1, I2, 2.2, 4.2, 3.2, resp. 3.3, 4.3, 2.3, I3, I4, 2.4, 4.4, 3.4), le deuxième trajet de courant d'alimentation étant séparé du premier aussi bien du côté de la tension que du côté de la masse, et
- du côté de la référence de masse, le premier et le deuxième trajets de courant d'alimentation sont reliés entre eux avec une faible résistance en courant continu et une faible inductance pour la formation d'un point de référence de masse (VS, 2.4) pour le circuit intégré (2).

2. Circuit intégré selon la revendication 1, **caractérisé en ce que** les moyens de filtrage (C1, C2, D) comprennent un premier condensateur de suppression (C1) et la bobine (D) et **en ce que** :
- le premier condensateur de suppression (C1) ferme, de manière externe, le premier trajet de courant d'alimentation (3.1, 4.1, 2.1, I1, I2, 2.2, 4.2, 3.2) pour les composantes de courant à haute fréquence (ih3) qui ne sont pas supprimées au moyen d'un condensateur interne de blocage (Cs) et
- la bobine (D) relie le premier trajet de courant d'alimentation (3.1, 4.1, 2.1, I1, I2, 2.2, 4.2, 3.2) au deuxième trajet de courant d'alimentation (3.3, 4.3, 2.3, I3, I4, 2.4, 4.4, 3.4), à chaque fois du côté de la tension d'alimentation qui est opposé à la masse.

3. Circuit intégré selon la revendication 1 ou 2, **caractérisé en ce que** les moyens de filtrage (C1, C2, D) comprennent un deuxième condensateur de suppression (C2) qui court-circuite le deuxième trajet de courant d'alimentation (3.3, 4.3, 2.3, I3, I4, 2.4, 4.4, 3.4) pour des composantes à haute fréquence de la deuxième zone (6).
